Europäisches Patentamt

European Patent Office

Office européen des brevets

(19)

(11)  EP 0 341 983 B1

## (12)  EUROPEAN PATENT SPECIFICATION

(45)  Date of publication and mention
of the grant of the patent:
**03.09.1997  Bulletin 1997/36**

(51)  Int Cl.6: **G03F 9/00**, G03F 7/20

(21)  Application number: **89304684.7**

(22)  Date of filing: **09.05.1989**

(54)  **Exposure system**

Belichtungssystem

Système d'exposition

(84)  Designated Contracting States:
**DE FR GB NL**

(30)  Priority:  **10.05.1988  JP  111457/88**

(43)  Date of publication of application:
**15.11.1989  Bulletin 1989/46**

(73)  Proprietor: **CANON KABUSHIKI KAISHA
Tokyo 146 (JP)**

(72)  Inventors:
• **Kawakami, Eigo
Ebina-shi Kanagawa-ken (JP)**
• **Yoshii, Minoru
Nakano-ku Tokyo (JP)**
• **Uzawa, Shunichi
Setagaya-ku Tokyo (JP)**

(74)  Representative:
**Beresford, Keith Denis Lewis et al
BERESFORD & Co.
2-5 Warwick Court
High Holborn
London WC1R 5DJ (GB)**

(56)  References cited:
FR-A- 2 274 073          US-A- 4 524 280
US-A- 4 724 466

• **JOURNAL OF VACUUM SCIENCE &
TECHNOLOGY B vol4,no 1 Jan-Feb.1986,pages
248-252,New York, US H.Betz et al: "resolution
limits in X-ray lithography calculated by means
of x-raylithography simulator XMAS"**
• **idem**
• **Nuclear Instruments and Methods in Physics
Research-Section A Vol.A246, no 1/3, 1986,
Amsterdam, NL p. 658-667, H.BETZ: "High
Resolution Lithography Using Synchrotron
Radiation".**

EP 0 341 983 B1

## Description

This invention relates to an exposure system for transferring onto a workpiece a pattern formed on an original. More particularly, the invention is concerned with an exposure system which uses a synchrotron orbital radiation (SOR) beam as an exposure energy and which is arranged to execute axis alignment between the exposure beam and a pattern transferring exposure station of the exposure system.

In the field of manufacture of semiconductor microcircuit devices such as integrated circuits (ICs), large scaled integrated circuits (LSIs) and the like, many proposals have been made to an exposure system using X-rays of a wavelength of an order of 0,1-15 nm, for example, in an attempt to meet the requirement of higher-resolution printing with further increase in the density of semiconductor devices. Among these X-ray exposure systems, those which use a synchrotron orbital radiation beam having high luminance are considered as being effective. In such an exposure system, a mask and a wafer are disposed. opposed to each other and in parallel to each other with a predetermined gap (clearance) maintained therebetween. A synchrotron orbital radiation beam is projected perpendicularly to the mask and the wafer, within a predetermined exposure area, by which a pattern formed on the mask is transferred onto the wafer having a suitable radiation-sensitive surface layer. Since, however, the structure of a light source device for providing the synchrotron orbital radiation beam is very bulky as as compared with a simple light source device used in traditional exposure systems, it is difficult to provide a major assembly of an exposure system, including a pattern transferring exposure station, as a unit with such a synchrotron orbital radiation source device. In consideration of this difficulty, the major assembly of the exposure system has to be separated from the radiation source device. This results in a possibility of a change in the relative attitude of the radiation source device and the major assembly of the exposure system, which causes an undesirable change in the angle of incidence of the exposure beam upon the pattern transferring exposure station. If this occurs, the pattern of the mask can not be transferred correctly and accurately.

Where a reflection mirror is used to set the angle of radiation of a synchrotron orbital radiation beam, if the set angle of such reflection mirror is not correct, the radiation beam flux can not impinge on a mask or wafer exactly perpendicularly or, in some cases, the position of incidence of the radiation beam flux deviates.

Reference is made to Nuclear Instruments and Methods in Physics Research - Section A, Vol. A246, No.1/3, (1986), Amsterdam, NL, p. 658-667, H Betz: "High Resolution Lithography Using Synchrotron radiation".

There is disclosed in U.S. 4724466 an exposure apparatus for use in manufacture in a semiconductor device in which a separate alignment light source and system is provided for effecting alignment of the mask and semiconductor substrate. However, this specification is not concerned with the problem dealt with by the present application and discussed earlier, but is concerned with the different problem of ensuring that vibrations caused by the operation of the laser used for exposing the semiconductor substrate through the mask, does not result in inaccuracies in the finished product.

In consideration of the foregoing, the present invention aims at solving problems involved in the axis alignment between a pattern transferring exposure station of an exposure system and a synchrotron orbital radiation beam as used exposure beam, to thereby allow that the exposure beam is projected perpendicularly upon an original or a workpiece, placed in the pattern transferring exposure station, and within a predetermined positional relationship and to execute higher-precision printing with less pattern transfer distortion.

The present invention is defined in claim 1, 8 and 10.

How the invention may be carried out will now be described by way of example only and with reference to the accompanying drawings in which:

In the accompanying drawings:-

Figure 1 is a schematic and diagrammatic view, showing a major part of an exposure system according to a first embodiment of the present invention.

Figure 2 is a schematic view, illustrating a view field of an autocollimator used in the Figure 1 embodiment.

Figure 3 is a graph representing a distribution of energy of radiation with respect to wavelength.

Figure 4 is an enlarged view showing a radiation blocking member usable in the present invention.

Figure 5 is a schematic view, representing the function of the radiation blocking member.

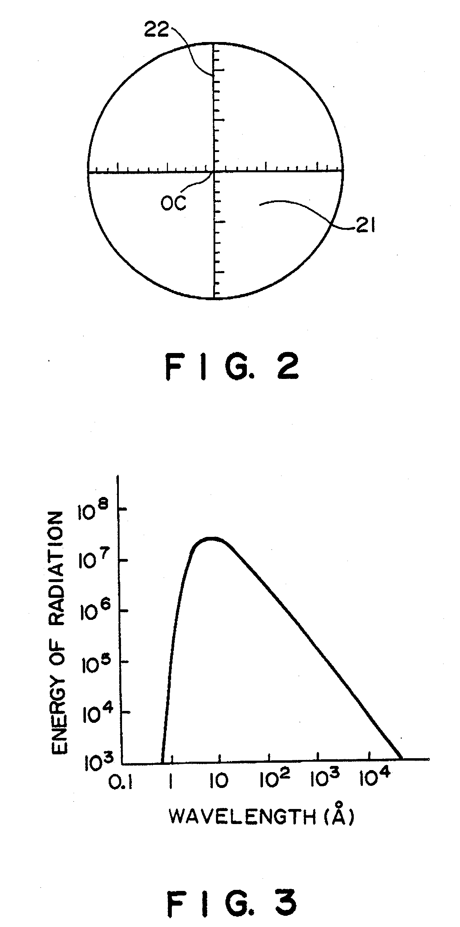

Referring first to Figure 3 which is a graph showing a distribution of a synchrotron orbital radiation beam energy with respect to the wavelength, the axis of abscissa denotes the wavelengths and the axis of ordinate depicts the relative value of the energy. It is seen from Figure 3 that in the synchrotron orbital radiation beam a light of wavelength, even it is within the visible region or a region adjacent thereto, has an energy which is about 1/100 of the maximum energy. In a first embodiment which will be described below, light in the visible region or a region adjacent thereto (within a range of about 380 - 900 nm), contained in the synchrotron orbital radiation beam, is used to execute the axis alignment of an exposure beam (SOR beam) and a pattern transferring exposure station of an exposure system.

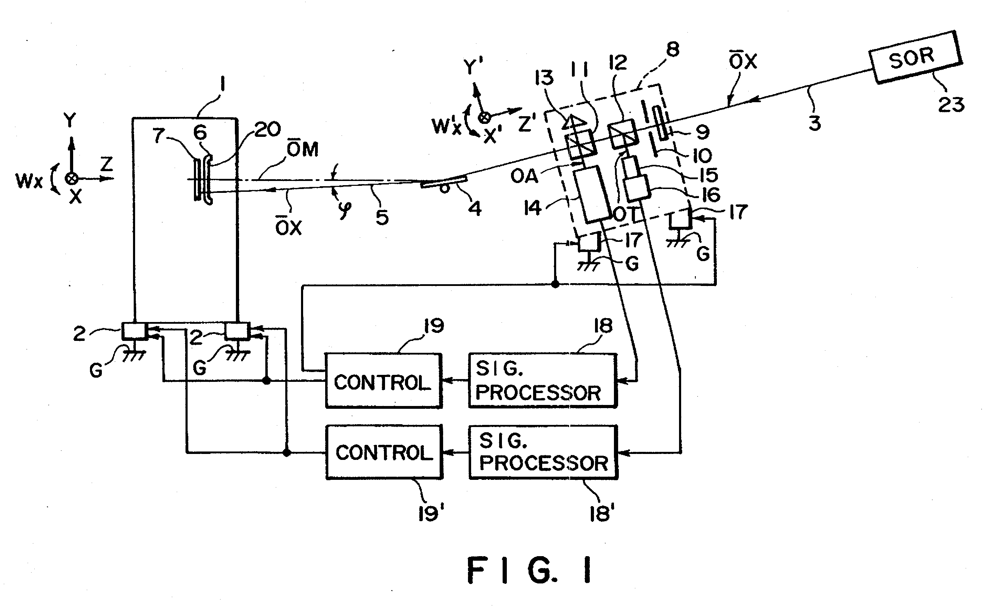

Figure 1 is a side view schematically and diagrammatically showing a major part of an exposure system according to the first embodiment of the present invention. Denoted in this Figure at 1 is a pattern transferring exposure station of an exposure system (X-ray exposure apparatus); at 2 is first driving means by which the pattern transferring exposure station 1 can be translated in X-axis and Y-axis directions as viewed in the drawing and also it can be rotationally moved in each of Wx and Wy directions about the X and Y axes, respectively. Denoted at 3 is a radiation beam (exposure beam) emanating from an electron orbital device (SOR) 23 and including an X-ray beam 5; at 4 is a mirror effective to transform the radiation beam 3 into an X-ray flux 5 having surface expansion, the transformation being made by, for example, oscillating the mirror itself; at 6 and 7 are a mask (in this example, which may be a dummy mask) and a wafer, respectively, which are placed in the pattern transferring exposure station 1; and at 8 is an axis adjusting optical system.

The axis adjusting optical system 8 comprises members denoted at 9 - 16 and being supported as a unit in a predetermined relationship. The optical system 8 can be translated in X' and Y' directions and also can be rotationally moved in Wx' and Wy' directions, by second driving means 17. Denoted at 9 is an X-ray cut filter made of a non-brown glass for example, and being operable to intercept a radiation beam component in the X-ray region but to transmit only the light in the visible region or a region adjacent thereto; at 10 is a light blocking plate having an aperture of a circular shape or cross shape, for example; at 11 and 12 are first and second beam splitters; at 13 is a corner cube; at 14 is an autocollimator; at 15 is a telescope; and at 16 is a TV camera. Those elements denoted at 11, 13 and 14 cooperate to provide a first observation optical system, while those elements denoted at 12, 15 and 16 cooperate to provide a second observation optical system. With respect to the center of the aperture of the light blocking plate 10 and to the first and second beam splitters 11 and 12, the first and second observation systems have their optical axes placed in a coaxial relationship.

Denoted at 18 and 18' are signal processors each being adapted to process a signal from the autocollimator 14 or the TV camera 16 and to transmit a resultant signal to an associated controller 19 or 19'. The controllers 19 and 19' are operable in response to the outputs from the signal processors 18 and 18', respectively, to produce control signals for actuating the first and second driving means 2 and 17. Denoted at 20 is a reference surface provided, in this example, on a reflective member for the axis alignment purpose. For example, the reference surface comprises an optical reflection flat surface having an alignment mark of a cross shape formed at the center thereof. The reflective member 6 may have a size and a shape, the same as those of a mask or a wafer used for production of microcircuits. In this illustrated example, the reflective member is disposed at the position 6 in place of such a mask.

Two coordinate systems as illustrated are determined so that the direction perpendicular to a reference plane G for setting of the pattern transferring exposure station 1 of the exposure system is depicted by Y; the direction of incidence of the X-ray flux 5 is depicted by Z; the direction parallel to the radiation beam 3 is depicted by Z' and the direction perpendicular to the radiation beam 3 is depicted by Y'.

The operation for the axis adjustment to be made in the X-ray exposure system structured as described above, will be explained below. It is to be noted here that, upon the axis adjustment, a mask stage or a wafer stage, which is included in the pattern transferring exposure station 1 and to which the reflective member 6 having the axis adjusting reference surface 20 is mounted is disposed at such position and angle which are preset as a reference for the exposure, and that the mirror 4 where it is of the type that the radiation beam is diverged by oscillation thereof is fixed at such angle which is the center of its maximum oscillation range. The mask stage to which a reflective member having a reference surface 20 for the axis adjustment may be mounted may be made to be only rotationally movable in a Wz direction (a rotational direction about the Z axis), with a result of coincidence of the center of the mask stage and the center of exposure area.

For this axis adjustment, (WZ), first the axis of the exposure beam $\overline{O}X$ and the axis of the axis adjusting optical system 8 are brought into alignment by using the first observation optical system (11, 13 and 14). Initially, the second driving means 17 operates to translate the axis adjusting optical system 8 in the X'-Y' plane through a predetermined distance to displace the same to a position traversing the radiation beam 3 and, thereafter, the radiation beam 3 is projected thereupon. The distance through which the axis adjusting optical system 8 is moved is set, while taking into account the retracted position of the optical system 8 itself and the position of the axis of the radiation beam 3 (having been designed), so that the center of the aperture stop of the light blocking plate 10 in the axis adjusting optical system 8 is located, after the movement of the optical system 8, just on or close to the axis of the radiation beam 3. While not shown in Figure 1, the position of the pattern transferring exposure station 1 and the position of the axis adjusting optical system 8 are monitored by using suitable means such as a laser interferometer, for example, the result of monitoring being fed back to the controller.

As the radiation beam 3 is projected on the axis adjusting optical system 8, the light component of the radiation beam 3 which is in the X-ray wavelength region is intercepted by the X-ray cut filter 9, and only the light in the visible region or in a region close thereto, passing in close proximity to the axis $\overline{O}X$, is allowed to pass therethrough and then is reduced to a minute diameter by means of the aperture of the light blocking plate 10. Thereafter, it passes through the second beam splitter 12 and enters into the first beam splitter 11. A portion of the light incident on the first beam splitter 11 is deflected by a first reflection surface and impinges on the corner cube 13. According to the characteristics of the corner cube 13, the inputted light emanates from the corner cube 13 along its oncoming path. Then, the light enters again the first beam splitter and, after passing therethrough, it is received by the autocollimator 14.

Thus, as illustrated in Figure 2, the light component in the visible region or a region adjacent thereto, contained in the radiation beam 3, appears within the view field of the autocollimator 14 in the form of a spot 21 having a shape as determined by the aperture of the light blocking plate 10. At this time, the projection of light by the autocollimator 14 itself is inhibited. Then, the second driving means 17 operates to move the axis adjusting optical system 8 so that the spot 21 comes to the center OC of the view field of the autocollimator 14 (i.e. the center of a cursor 22 or, alternatively, it may be a blade means having a minute aperture which represents the center position of the view field of the autocollimator). As is well known in the art, an autocollimator comprises a projection optical system for projecting an index, such as a cursor, upon a surface of the subject of measurement, and a re-imaging optical system for re-imaging an image projected on the subject of measurement through the projection optical system. The projection optical system and the re-imaging optical system have their optical axes placed in a coaxial relationship. Thus, the present embodiment uses such a common axis of the autocollimator as an optical axis OA of the autocollimator.

When the above coincidence is accomplished, the axis OX of the radiation beam 3 and the axis OA of the autocollimator 14 are brought into a coaxial or a substantially coaxial relationship.

More specifically, in this occasion, the signal processor 18 is used to process the information as obtained from the autocollimator to detect the position of the spot 21 upon the cursor 22 of the autocollimator. In accordance with a detected value, the controller 19 controls to actuate the driving means 17 so that the spot position comes to the center OC.

Subsequently, the second observation optical system is used additionally, to accomplish the axis alignment between the axis adjusting optical system 8 and the pattern transferring exposure station 1. Initially, by using the telescope 15 and the TV camera 16 and through the second beam splitter 12, a mark (of a cross shape, for example) which is provided at the center of the reference surface 20 is observed. Then, by using the first driving means 2, the pattern transferring exposure station 1 is displaced in X and Y directions so that the center of the mark becomes coincident with the center of a spot on the reference surface 20, which is seen at the middle of the picture plane (the spot being provided by a portion of the radiation beam 3 in the visible region or adjacent thereto, having been transmitted through the second beam splitter 12). At this time, the mark on the reference surface is illuminated by means of an unshown illumination source. The control of the driving means 2 at this time is executed by the controller 19'. More specifically, the signal processor 18' operates to process the information as obtained by the TV camera 16 to detect the positions of the mark and the spot on the reference surface 20, in response to which the controller 19' controls the driving means 2.

When, with the illumination by the light from the autocollimator 14, the cursor 22 (Figure 2) of cross shape is projected upon the reference surface 20 through a second reflection surface of the first beam splitter 11, any inclination of a normal to the reference surface 20 (i.e. the axis of the pattern transferring exposure station 1) with respect to the axis of the exposure beam can be detected, on the basis of any deviation between the cursor 22 and a reflection image within the view field of the autocollimator 14 by the reference surface 20. Thus, the pattern transferring exposure station 1 is moved rotationally in the Wx and Wy directions by the first driving means 2, so as to remove the inclination.

More specifically, in this occasion, the the information as obtained from the autocollimator is processed by the signal processor 18, whereby any deviation between the reflection image and the cursor 22 is detected. In response to a detected value, the controller 19 controls the driving means 2.

If, by this adjustment, the spot on the reference surface 20 shifts from the center of the mark provided on the reference surface 20, the pattern transferring exposure station 1 is displaced in the X and Y directions in the manner described hereinbefore and, similarly, the inclination of the reference surface 20 is adjusted by the rotational movement in the Wx and Wy directions.

By repeating the above-described adjustment to accomplish the axis adjustment between the pattern transferring exposure station 1 and the axis adjusting optical system 8, finally the axis OX of the exposure beam and the axis OM of the pattern transferring exposure station 1 can be aligned with each other. After the adjustment is completed, the axis adjusting optical system 8 is retracted to a position not intercepting the radiation beam 3, whereby the exposure system becomes ready for the exposure.

An X-ray beam has an angle of divergence of 1 miliradian and, therefore, a mechanical precision not greater than 0.1 miliradian may be required. However, an autocollimator can provide a precision not greater than 1 second (5 microradians), thus, it is sufficient.

In the present embodiment, the axis adjusting optical system 8 is disposed between the radiation beam source 23 and the mirror 4. However, it may be provided between the mirror 4 and the pattern transferring exposure station 1.

Light blocking plate 10 usable in the present invention will be explained in greater detail.

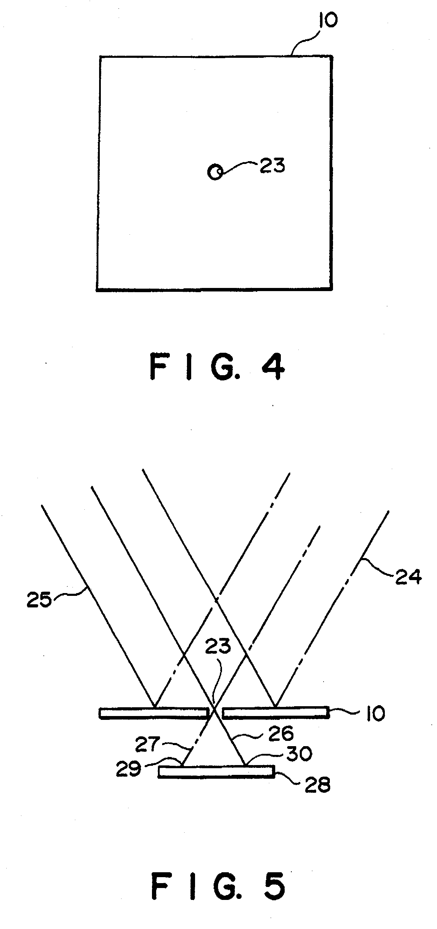

Figure 4 is a top plan view of such a light blocking plate 10. As shown, it is provided with an aperture 23 whose diameter is set sufficiently small, as compared with the diameter or size of the radiation beam 3. The light blocking plate 10 can function to restrict or reduce the diameter of the radiation beam, and this provides various advantages which will be explained in conjunction with Figure 5.

Denoted in Figure 5 at 24 and 25 are different radiation beams projected on the light blocking plate 10 in different directions. Reference numerals 26 and 27 denotes those of the radiation beams 24 and 25 which pass through the light blocking plate 10. Denoted at 28 is a light receiving sensor which may comprise a linear image sensor, for example. Reference numerals 29 and 30 depict the positions on the sensor 28 at which the axes 26 and 27 intersect with the sensor 28. The sensor 28 and the light blocking plate 10 are made integrally with each other.

In operation, the radiation beams 24 and 25 are restricted and reduced to sufficiently small diameters, by the light blocking plate 10, and are received by the sensor 28. The direction of projection of each radiation beam 24 or 25 upon or with respect to the light blocking plate 10 and the sensor 28 can be detected on the basis of the position of incidence thereof upon the sensor 28. If such light blocking plate 10 is not used, it is necessary to use a large sensor having a wide light receiving surface, which is larger than the cross-sectional area of the radiation beams 24 and 25, in order to detect the direction of projection of these beams. This is disadvantage since the structure becomes bulky and expensive.

## Claims

1. An exposure apparatus comprising an exposure unit (1) for supporting an original (6) having a pattern and a substrate (7);

a radiation source (23) for providing a radiation beam (3) for transferring the pattern of the original onto the substrate; wherein the radiation source (23) for providing the radiation beam generates a synchrotron orbital radiation beam,

characterised in that there are provided

filter means (9) for producing a light beam component from said radiation beam; a reflective member (20) in said exposure unit arranged perpendicular to the light beam; detecting means (11, 13, 14; 15, 16) for receiving said light beam reflected by the reflective member, said detecting means serving to detect the angle of incidence of the synchrotron radiation beam with respect to the surface of the reflective member; and adjusting means (2; 17, 18, 18'; 19; 19') operable in response to the output of said detecting means to correct any deviation of the position of the pattern of the original on the substrate due to the angle of incidence.

2. An apparatus as claimed in claim 1, characterised in that said adjusting means (2) is adapted to move the exposure unit relative to the radiation beam to adjust the angle of incidence of the radiation beam.

3. An apparatus as claimed in Claim 1 or 2, characterised in that a blocking member (10) is provided to narrow the light beam to form a spot on said reflective member of said exposure unit for detection by said detecting means.

4. An apparatus as claimed in Claim 3, characterised in that said filter means is disposed upstream of said blocking member with respect to the direction of the synchrotron radiation beam.

5. An apparatus as claimed in Claim 3 or 4, characterised in that said blocking member and said filter are mounted so as to be movable out of the path of the synchrotron radiation beam for the purpose of an exposure operation.

6. An apparatus as claimed in any one of Claims 1-5, characterised in that said filter means serves to extract a visible wavelength component of the synchrotron radiation.

7. An apparatus as claimed in any one of Claims 1-6, characterised in that the original is a mask having a circuit pattern and the substrate is a semiconductor wafer.

8. A method of exposure of a mask pattern upon a semiconductor wafer using an apparatus including an exposure unit for supporting the mask and wafer, comprising the steps of

a. providing a synchrotron orbital radiation beam,
b. filtering said beam by placing a filter in the path of said beam to produce a light beam of a desired wavelength band,
c. projecting said light beam into a reflective surface provided on said exposure unit,
d. deriving an output signal indicative of the angle of incidence of the light beam with respect to the reflective surface by means of a detector which receives an image from the reflective surface and determines the deviation of the light beam,
e. adjusting the apparatus in dependence upon the output signal from said detector to correct any deviation of the position of the pattern of the original on the substrate due to the angle of incidence of the light beam on said mask,
f. removing the filter from the path of the synchrotron orbital radiation beam, and
g. effecting exposure, by means of the synchrotron orbital radiation beam, of said substrate to form thereon a pattern of said mask.

9. A method of manufacturing a semiconductor integrated circuit device including the step of exposing a mask pattern upon a semiconductor wafer by the method claimed in claim 8.

10. An exposure device for use in an exposure apparatus as claimed in claim 1 or in the method of claim 8, said exposure device comprising an exposure unit (1) for supporting an original (6) having a pattern and a substrate (7) characterised in that there are provided:

> filter means (9) for producing a light beam component from an incoming beam of synchroton orbital radiation;
> a reflective member (20) in said exposure unit arranged perpendicular to the path of the light beam;
> detecting means (11, 13, 14; 15, 16) arranged to receive said light beam reflected by the reflective member, said detecting means being arranged to detect the angle of incidence of the synchrotron radiation beam with respect to the surface of the reflective member; and
> adjusting means (2; 17, 18, 18'; 19; 19') operable in response to the output of said detecting means to correct any deviation of the position of the pattern of the original on the substrate due to the angle of incidence.

11. The exposure device of claim 10, having the features of any of claims 2 to 7.

**Patentansprüche**

1. Belichtungsvorrichtung mit einer Belichtungseinheit (1) zum Stützen einer Vorlage (6) mit einem Muster und eines Substrats (7);

> einer Strahlungsquelle (23) zum Vorsehen eines Strahlungsstrahls (3) zum Übertragen des Musters der Vorlage auf das Substrat; wobei die Strahlungsquelle (23) zum Vorsehen des Strahlungsstrahls einen synchrotronen Umlaufstrahlungsstrahl erzeugt,

**dadurch gekennzeichnet, daß**

> eine Filtereinrichtung (9) zum Erzeugen einer Lichtstrahlkomponente von dem Strahlungsstrahl;
> ein reflektierendes Element (20) in der Entwicklungseinheit, das senkrecht zum Lichtstrahl angeordnet ist;
> eine Erfassungseinrichtung (11, 13, 14; 15, 16) zum Aufnehmen des von dem reflektierenden Element reflektierten Lichtstrahls, wobei die Erfassungseinrichtung zum Erfassen des Einfallswinkels des synchrotronen Strahlungsstrahls bezüglich der Oberfläche des reflektierenden Elements dient; und
eine Einstelleinrichtung (2; 17, 18, 18'; 19; 19') vorgesehen ist, die ansprechend auf den Ausgang der Erfassungseinrichtung betreibbar ist, um jegliche Abweichung der Position des Musters der Vorlage auf dem Substrat aufgrund des Einfallswinkels zu korrigieren.

2. Vorrichtung nach Anspruch 1,
**dadurch gekennzeichnet, daß**
die Einstelleinrichtung (2) dazu angepaßt ist, die Entwicklungseinheit gegenüber dem Strahlungsstrahl zu bewegen, um den Einfallswinkel des Strahlungsstrahls einzustellen.

3. Vorrichtung nach Anspruch 1 oder 2,
**dadurch gekennzeichnet, daß**
ein Blockierelement (10) vorgesehen ist, um den Lichtstrahl zu verengen, so daß ein Lichtfleck auf dem reflektierenden Element der Entwicklungseinheit zum Erfassen durch die Erfassungseinrichtung geformt wird.

4. Vorrichtung nach Anspruch 3,
**dadurch gekennzeichnet, daß**
die Filtereinrichtung stromaufwärts des Blockierelements bezüglich der Richtung des synchrotronen Strahlungsstrahls angeordnet ist.

5. Vorrichtung nach Anspruch 3 oder 4,
**dadurch gekennzeichnet, daß**
das Blockierelement und der Filter so montiert sind, daß sie aus der Bahn des synchrotronen Strahlungsstrahls zum Zweck des Belichtungsvorgangs herausbewegbar sind.

6. Vorrichtung nach einem der Ansprüche 1 bis 5,
**dadurch gekennzeichnet, daß**
die Filtereinrichtung dazu dient, die sichtbare Wellenlängenkomponente der synchrotronen Strahlung herauszulösen.

7. Vorrichtung nach einem der Ansprüche 1 bis 6,
**dadurch gekennzeichnet, daß**
die Vorlage eine Maske ist, die ein Schaltungsmuster hat, und das Substrat ein Halbleiter-Wafer ist.

8. Verfahren zum Belichten eines Maskenmusters auf einen Halbleiter-Wafer unter Verwendung einer Vorrichtung, die eine Belichtungseinheit zum Stützen der Maske und des Wafers umfaßt, mit folgenden Schritten:

> a. Vorsehen eines synchrotronen Umlaufstrahlungsstrahls,

b. Filtern des Strahls, indem ein Filter in die Bahn des Strahls gesetzt wird, um einen Lichtstrahl mit einem gewünschten Wellenlängenband zu erzeugen,

c. Projizieren des Lichtstrahls in eine reflektierende Fläche, die auf der Entwicklungseinheit vorgesehen ist,

d. Ableiten eines Ausgangssignals, das den Einfallswinkel des Lichtstrahls gegenüber der reflektierenden Fläche anzeigt, mittels eines Detektors, der ein Bild von der reflektierenden Fläche aufnimmt und die Abweichung des Lichtstrahls bestimmt,

e. Einstellen der Vorrichtung in Abhängigkeit des Ausgangssignals von dem Detektor, um jegliche Abweichung der Position des Musters der Vorlage auf dem Substrat aufgrund des Einfallswinkels des Lichtstrahls auf die Maske zu korrigieren,

f. Entfernen des Filters aus der Bahn des synchrotronen Umlaufstrahlungsstrahls, und

g. Bewirken einer Belichtung des Substrats mittels des synchrotronen Umlaufstrahlungsstrahls, um darauf ein Muster der Maske auszubilden.

9. Verfahren zum Herstellen einer integrierten Halbleiterschaltungsvorrichtung, das den Schritt der Belichtung eines Maskenmusters auf einen Halbleiter-Wafer durch das in Patentanspruch 8 beanspruchte Verfahren umfaßt.

10. Belichtungsvorrichtung zur Verwendung in einem Belichtungsgerät nach Anspruch 1 oder in dem Verfahren nach Anspruch 8, wobei die Belichtungsvorrichtung eine Belichtungseinheit (1) aufweist, um eine Vorlage (6) mit einem Muster und ein Substrat (7) zu stützen,
**dadurch gekennzeichnet, daß**

eine Filtereinrichtung (9) zum Erzeugen einer Lichtstrahlkomponente von einem eingehenden Strahl einer synchotronen Umlaufstrahlung;

ein reflektierendes Element (20) in der Belichtungseinheit, das senkrecht zur Bahn des Lichtstrahls angeordnet ist;

eine Erfassungseinrichtung (11, 13, 14; 15, 16), die dazu angeordnet ist, den durch das reflektierende Element reflektierten Lichtstrahl aufzunehmen, wobei die Erfassungseinrichtung dazu angeordnet ist, den Einfallswinkel des synchotronen Strahlungsstrahls bezüglich der Oberfläche des reflektierenden Elements zu erfassen; und

eine Einstelleinrichtung (2; 17, 18, 18'; 19; 19') vorgesehen sind, die ansprechend auf den Ausgang der Erfassungseinrichtung betätigbar ist, um jegliche Abweichung der Position des Musters der Vorlage auf dem Substrat aufgrund des Einfallswinkels zu korrigieren.

11. Belichtungsvorrichtung nach Anspruch 10, mit den Merkmalen von einem der Ansprüche 2 bis 7.

**Revendications**

1. Appareil d'exposition comprenant une unité (1) d'exposition pour supporter un original (6) ayant un motif et un substrat (7) ;

une source (23) de rayonnement pour produire un faisceau (3) de rayonnement pour transférer le motif de l'original sur le substrat ; dans lequel la source (23) de rayonnement pour produire le faisceau de rayonnement génère un faisceau de rayonnement orbital synchrotron,

caractérisé en ce qu'il est prévu :

des moyens (9) de filtrage pour produire une composante de faisceau lumineux à partir dudit faisceau de rayonnement ;
un élément (20) réfléchissant dans ladite unité d'exposition agencé perpendiculairement au faisceau lumineux ;
des moyens (11, 13; 14, 15, 16) de détection pour recevoir ledit faisceau lumineux réfléchi par l'élément réfléchissant, lesdits moyens de détection servant à détecter l'angle d'incidence du faisceau de rayonnement synchrotron par rapport à la surface de l'élément réfléchissant ; et
des moyens (2; 17, 18, 18'; 19; 19') pouvant fonctionner en réponse à la sortie desdits moyens de détection pour corriger un éventuel écart de la position du motif de l'original sur le substrat qui est dû à l'angle d'incidence.

2. Appareil selon la revendication 1, caractérisé en ce que lesdits moyens (2) d'ajustement sont conçus pour déplacer l'unité d'exposition par rapport au faisceau de rayonnement afin d'ajuster l'angle d'incidence du faisceau de rayonnement.

3. Appareil selon la revendication 1 ou 2, caractérisé en ce qu'un élément (10) d'occultation est prévu pour réduire le faisceau lumineux afin de former un point sur ledit élément réfléchissant de ladite unité d'exposition pour sa détection par lesdits moyens de détection.

4. Appareil selon la revendication 3, caractérisé en ce que lesdits moyens de filtrage sont disposés en amont dudit élément d'occultation par rapport à la direction du faisceau de rayonnement synchrotron.

5. Appareil selon la revendication 3 ou 4, caractérisé en ce que ledit élément d'occultation et ledit filtre sont montés de façon à pouvoir être écartés du chemin du faisceau de rayonnement synchrotron dans le but d'une opération d'exposition.

6. Appareil selon l'une quelconque des revendications 1-5, caractérisé en ce que lesdits moyens de filtrage servent à extraire une composante de longueur d'onde visible du rayonnement synchrotron.

7. Appareil selon l'une quelconque des revendications 1-6, caractérisé en ce que l'original est un masque ayant un motif de circuit et le substrat est une plaquette de semiconducteur.

8. Procédé d'exposition d'un motif de masque sur une plaquette de semiconducteur en utilisant un appareil comportant une unité d'exposition pour supporter le masque et la plaquette, comprenant les étapes qui consistent :

a. à produire un faisceau de rayonnement orbital synchrotron,
b. à filtrer ledit faisceau en plaçant un filtre sur le chemin dudit faisceau afin de produire un faisceau lumineux ayant une bande de longueurs d'onde désirée,
c. à projeter ledit faisceau lumineux sur une surface réfléchissante prévue sur ladite unité d'exposition,
d. à déterminer un signal de sortie représentatif de l'angle d'incidence du faisceau lumineux par rapport à la surface réfléchissante au moyen d'un détecteur qui reçoit une image de la surface réfléchissante et détermine l'écart du faisceau lumineux,
e. à ajuster l'appareil en fonction du signal de sortie dudit détecteur pour corriger un éventuel écart de la position du motif de l'original sur le substrat qui est dû à l'angle d'incidence du faisceau lumineux sur ledit masque,
f. à retirer le filtre du chemin du faisceau de rayonnement orbital synchrotron, et
g. à effectuer une exposition dudit substrat au moyen du faisceau de rayonnement orbital synchrotron, pour former sur celui-ci un motif dudit masque.

9. Procédé de fabrication d'un dispositif à circuit intégré à semiconducteur comportant l'étape consistant à exposer un motif de masque sur une plaquette de semiconducteur par le procédé revendiqué dans la revendication 8.

10. Dispositif d'exposition pour une utilisation dans un appareil d'exposition selon la revendication 1 ou dans le procédé selon la revendication 8, ledit dispositif d'exposition comprenant une unité (1) d'exposition pour supporter un original (6) ayant un motif et un substrat (7), caractérisé en ce qu'il est prévu :

des moyens (9) de filtrage pour produire une composante de faisceau lumineux à partir d'un faisceau d'entrée de rayonnement orbital synchrotron ;
un élément (20) réfléchissant dans ladite unité d'exposition agencé perpendiculairement au chemin du faisceau lumineux ;
des moyens (11, 13, 14; 15, 16) de détection agencés pour recevoir ledit faisceau lumineux réfléchi par l'élément réfléchissant, lesdits moyens de détection étant conçus pour détecter l'angle d'incidence du faisceau de rayonnement synchrotron par rapport à la surface de l'élément réfléchissant ; et
des moyens (2; 17, 18, 18'; 19; 19') pouvant fonctionner en réponse à la sortie desdits moyens de détection pour corriger un éventuel écart de la position du motif de l'original sur le substrat qui est dû à l'angle d'incidence.

11. Dispositif d'exposition selon la revendication 10, ayant les caractéristiques indiquées dans l'une quelconque des revendications 2 à 7.

F I G. I

EP 0 341 983 B1

F I G. 2

F I G. 3

F I G. 4

F I G. 5